# FASCICULE DE BREVET EUROPEEN

(11) **EP 0 970 438 B1**
(45) Date de publication et mention de la délivrance du brevet: **09.10.2002**
(21) Numéro de dépôt: 98917221.8
(22) Date de dépôt: 25.03.1998
(51) Int. Cl.: G06K 19/077

(54) **PROCEDE DE FABRICATION DE CARTE A PUCE OU DISPOSITIF ELECTRONIQUE ANALOGUE**
HERSTELLUNGSVERFAHREN EINER CHIPKARTE ODER EINES VERGLEICHBAREN ELEKTRONISCHEN GERÄTES
METHOD FOR MAKING SMART CARD OR SIMILAR ELECTRONIC DEVICE

(30) Priorité: 27.03.1997 FR 9704093
(43) Date de publication de la demande: 12.01.2000
(60) Demande divisionnaire: 02015180.9
(73) Titulaire: GEMPLUS, 13881 Gémenos Cédex (FR)
(72) Inventeur: BLANC, René-Paul, F-83860 Nans Les Pins (FR); FIDALGO, Jean-Christophe, F-13420 Gémenos (FR); PATRICE, Philippe Résidence des deux Moulins, F-13190 Allauch (FR)
(86) Numéro de dépôt international: FR9800592
(87) Numéro de publication internationale: WO98044452

(56) Documents cités:
- EP-A- 0 762 323
- DE-A- 4 325 458
- FR-A- 2 624 284
- JP-A- 7 321 438
- US-A- 5 969 415

## Description

L' invention concerne la fabrication de dispositifs électroniques comportant au moins un microcircuit qui est noyé dans une carte support et relié à des éléments d'interface constitués par un bornier et/ou une antenne, tels que les cartes à circuit(s) intégré(s) avec ou sans contact, aussi appelées cartes à puce.

L'invention s'applique aussi aux étiquettes électroniques qui sont utilisées pour l'identification de produits et que l'on peut assimiler à des cartes à puces sans contact .

L' invention concerne plus particulièrement la réalisation des connexions entre le microcircuit et les éléments d'interface, tels que le bornier et/ou une antenne.

Le document US-A-5969415 décrit un dispositif de stockage de données, dans lequel une puce est reliée à une bobine d'antenne par des liaisons filaires soudées à des tiges de contact. Ces tiges sont fixées à la bobine par une colle électriquement conductrice, préalablement introduite dans des passages correspondants par une technique dite de "dispense".

Le document JP-A-07321438 décrit un montage sur une carte de circuit imprimé par sérigraphie puis durcissement thermique, d'une puce avec sa face active tournée vers ce circuit. Des bossages de la puce sont ensuite revêtus d'un adhésif conducteur durcissable à la chaleur. Une autre réalisation montre un pacquetage à puce semi conductrice avec une connexion filaire dite "wire bonding".

FR-A-2 624 284 divulgue une carte à puce où les connexions électriques d'un composant électronique sont reliées à des métallisations de la carte par une substance liquide ou visqueuse. Les connexions du composant sont introduites dans des canaux contenant cette substance.

Il existe des procédés basés sur l'assemblage de la puce dans un sous-ensemble appelé micromodule.

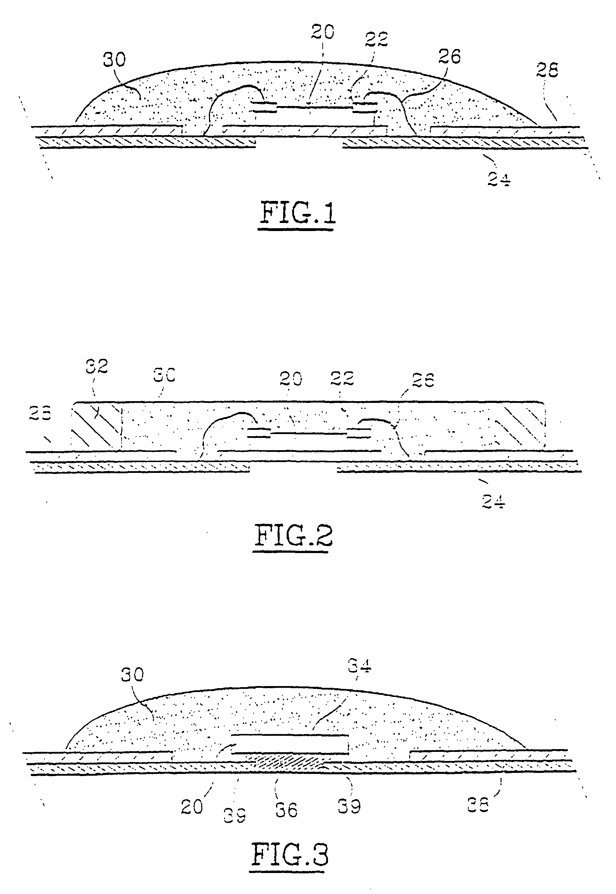

Un premier procédé, qui est illustré à la figure 1, comprend tout d'abord le collage de la puce ou microcircuit 20 ("die attach") qui consiste à coller une puce 20, provenant d'une plaquette tronçonnée par sciage, en disposant sa face active avec ses plots de sortie 22 vers le haut et en collant la face opposée sur une plaque support diélectrique 28 en utilisant une colle qui peut être conductrice, le collage étant réalisé sur un circuit imprimé ou sur un film.

On effectue ensuite le microcâblage ou soudage des connexions ("wire bonding") qui consiste à réaliser par des soudures la connexion des plots de sortie 22 de la puce 20 avec le bornier de contacts 24 de la plaque de circuit imprimé.

Enfin, on effectue un enrobage en boîtier ("potting") qui consiste à protéger la puce 20 et les fils de connexion soudés 26 en utilisant une résine 30 qui peut être, par exemple, à base de silicone ou de polyuréthanne.

Dans une variante de ce procédé, qui est illustrée à la figure 2, on utilise un anneau métallique périphérique 32 pour rigidifier le micromodule autour de la résine 30.

Dans une autre variante de ce procédé ("flip-chip"), on utilise une puce à bosses ou protubérances ("bumps") que l'on place avec sa face active vers le bas, la connexion électrique étant assurée soit par des bosses métalliques ou en polymère, soit par un adhésif anisotrope.

Dans d'autres variantes, on utilise la technique du soudage sur bande ("tape aùtomated bonding ou TAB"), illustré sur la figure 3 selon laquelle la puce 34 est collée au moyen d'une colle anisotrope 36 et les différents contacts du film 38 sont soudés par thermocompression sur la puce 34 qui comporte des bosses 39.

Il existe aussi des procédés de fabrication des cartes à puce à contacts n'utilisant pas de micromodule. Un premier procédé est basé sur l'utilisation de la sérigraphie pour former des contacts et assurer l'interconnexion de la puce.

Un autre procédé fait appel à une métallisation en trois dimensions du corps de la carte, suivie d'un report de la puce par une technologie classique (collage plus microcâblage) ou par la technique du "flip-chip" décrite ci-dessus.

Dans les procédés utilisant un micromodule les coûts associés sont limités par le prix du film. De plus, il est souvent nécessaire, après l'opération d'encapsulation, de fraiser la résine pour réduire l'épaisseur de l'ensemble. Cette opération est difficile à réaliser car la résine est polymérisée et donc très rigide. Ce fraisage est la cause principale des rebuts de fabrication.

Dans le premier procédé sans micromodule décrit ci-dessus, ce dernier se trouve en surface et il est donc soumis aux contraintes extérieures, ce qui augmente fortement le coût associé. En ce qui concerne le deuxième procédé sans micromodule, le nombre d'étapes est important, ce qui en augmente le coût.

Il n'est donc pas envisageable d'utiliser une telle technologie pour la fabrication de cartes à puce de grande taille.

Il existe deux grandes familles de procédés de fabrication des cartes à puce sans contact. La première utilise une antenne réalisée par bobinage qui est soit soudée à un micromodule contenant la puce, soit soudée directement à une puce comportant des bosses ("bumps"). Une telle technique ne peut être utilisée que pour des puces de fonctionnement simple.

La seconde famille fait appel à une antenne "à plat" qui peut avoir la forme d'une spirale périphérique rectangulaire ou toute autre forme appropriée. Une telle antenne peut être réalisée par photogravure, découpe mécanique. impression au tampon (tampographie), impression par sérigraphie ou impression offset d'une encre conductrice. La puce est rapportée ensuite sur l'antenne au moyen de la technique "flip-chip" ou d'une technique classique.

Dans ces procédés de fabrication de cartes a puce sans contact, on utilise la fabrication de micromodules qui, comme indiqué ci-dessus, comporte de nombreuses étapes d'assemblage de la puce et implique un coût important, ou la technique "flip-chip" dont la cadence est limitée et le coût d'installation est particulièrement élevé.

En ce qui concerne les cartes à puce hybrides, leurs procédés combinent les inconvénients précités pour les cartes à puce à contacts et sans contact.

Le problème à la base de l'invention est de disposer d'un procédé de réalisation des connexions entre un microcircuit et les éléments d'interface, dans un dispositif électronique (tel qu'une carte à puce) comprenant au moins un microcircuit qui est noyé dans une carte support et qui comporte des plots de sortie reliés à des éléments d'interface constitués par un bornier et/ou une antenne qui ne présente pas les inconvénients précités et qui permet en particulier de réduire le coût et le pourcentage de rebuts de fabrication et cela sans réaliser des micromodules.

Le procédé selon l'invention est défini dans la revendication 1.

Ce procédé permet de supprimer la réalisation d'un micromodule et de réduire le nombre des étapes de fabrication.

De plus, on obtient des connexions souples alors que les connexions de type connu sont rigides ou semi-rigides et cela réduit fortement le taux de rebut à la fabrication.

Avantageusement, le bornier est aussi réalisé par dépôt de substance conductrice à faible viscosité.

Ceci permet de simplifier encore le procédé, la réalisation du bornier et de ses connexions se faisant en une seule opération.

Avantageusement, l'antenne est aussi réalisée par dépôt de substance conductrice à faible viscosité.

Ceci permet de simplifier la fabrication et d'augmenter les performances de l'antenne.

De préférence, la substance est une résine polymère chargée de particules conductrices ou intrinsèquement conductrices.

D'autres caractéristiques et avantages de l'invention apparaîtront à la lecture de la description détaillée qui suit pour la compréhension de laquelle on se reportera aux dessins annexés dans lesquels :
- la figure 1 est un schéma en section transversale qui illustre un procédé connu de fabrication de carte à puce à contact ;
- la figure 2 illustre une variante du procédé de la figure 1 ;
- la figure 3 illustre une autre variante du procédé de la figure 1 ;
- la figure 4 illustre un premier mode de réalisation du procédé selon l'invention appliqué à la fabrication de cartes à puces à contacts ;
- la figure 5 illustre une variante du procédé de la figure 4 ;
- la figure 6 illustre un mode de réalisation appliqué à la fabrication de cartes à puces sans contact ;
- les figures 7 à 10 illustrent une variante du procédé de la figure 6 ;
- la figure 11 illustre un mode de réalisation appliqué à la fabrication de cartes à puces hybrides ; et
- les figures 12 et 13 illustrent un mode de réalisation appliqué à la fabrication d'étiquettes électroniques.

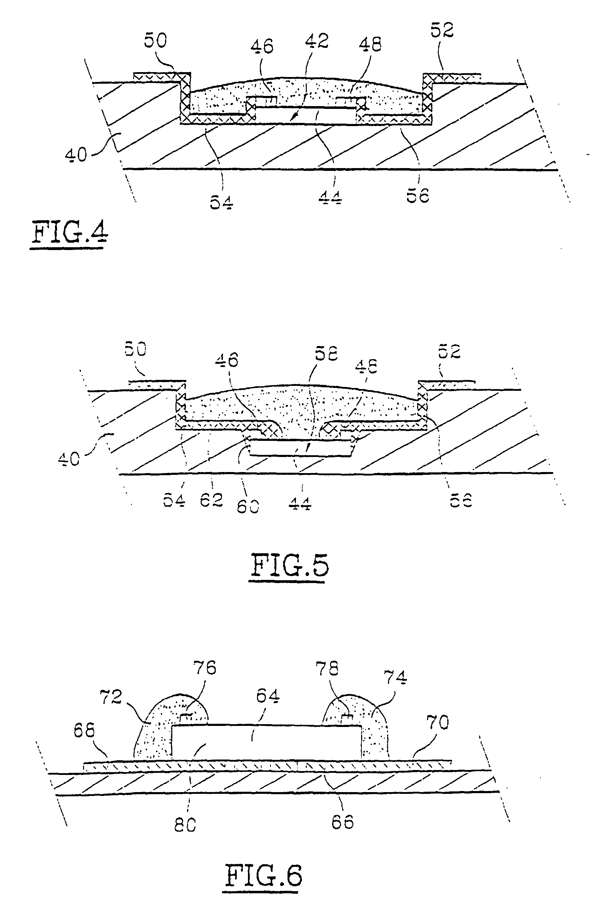

La figure 4 représente une carte à puce à contacts fabriquée conformément à un procédé selon l'invention.

Dans une première étape, on réalise un corps de carte 40 comportant une cavité 42 qui peut être réalisée par moulage par injection ou par colamination de feuilles thermoplastiques suivie d'un usinage de la cavité.

Dans une deuxième étape, on met la puce 44 dans la cavité avec sa face active. en particulier ses plots de sortie 46 et 48, vers le haut et on la fixe par exemple par collage. On peut aussi procéder à un chauffage local de la cavité puis à une mise en place de la puce dans la matière thermoplastique ainsi fondue. Il n'est pas nécessaire que la face active de la puce soit au même niveau que le fond de la cavité.

Dans une troisième étape, on réalise le bornier de contacts et les connexions avec les plots de sortie 46 et 48 er déposant une substance conductrice à faible viscosité par exemple une résine polymère chargée de particules conductrices ou intrinsèquement conductrices, par une technique dite de "dispense" selon laquelle on applique une substance liquide ou de faible viscosité au moyen d'une seringue ou analogue à débit et ouverture commandés.

Cette opération de dépôt, appelée dans la suite dispense, est réalisée par exemple au moyen d'une installation commercialisée sous la dénomination CAM/ALOT par la société américaine Camelot Systems Inc. et utilisée pour la réalisation en ligne de circuits électroniques. Les paramètres de déplacement et d'ouverture de la seringue sont commandés par un programme informatique.

On réalise ainsi des dépôts de résine conductrice qui constituent les contacts 50 et 52 du bornier d'interface de la carte à puce et les connexions 54 et 56 entre ces contacts 50 et 52 et les plots de sortie 46 et 48 de la puce. L'épaisseur de ces dépôts peut être beaucoup plus élevée que par un procédé de sérigraphie," ce qui permet d'obtenir des sections plus importantes et donc de faibles résistances de contact.

Avantageusement, les plots de sortie 46 et 48 comportent une métallisation inoxydable, par exemple en nickel, titane ou tungstène.

On peut aussi munir ces plots de bosses (bumps) de manière à améliorer le contact électrique.

Pour corriger les erreurs de positionnement de la puce, on peut prévoir une régulation utilisant une image de la puce fournie par un système de vision assisté par ordinateur (VAO).

On choisit de préférence, des résines dont la température d'activation est inférieure à la température de ramollissement de la matière thermoplastique du corps de la carte.

La figure 5 illustre une variante du procédé précité dans laquelle on réalise une cavité à deux niveaux, c'est-à-dire une cavité 58 présentant un évidement 60 dans son fond. Les dimensions de cet évidement sont suffisantes pour recevoir la puce 44 et sa profondeur est sensiblement égale à l'épaisseur de la puce de telle sorte que la face active de celle-ci se trouve au niveau du fond 62 de la cavité 58. Grâce à cette disposition, on évite un deuxième changement de pente des cordons de résine dans la cavité, ce qui facilite le contact de la résine conductrice avec les plots ce sortie 46 et 48.

Dans une quatrième et dernière étape, on réalise une encapsulation (potting) qui, consiste à protéger la puce en utilisant une résine, par exemple à base de silicone ou de polyuréthanne.

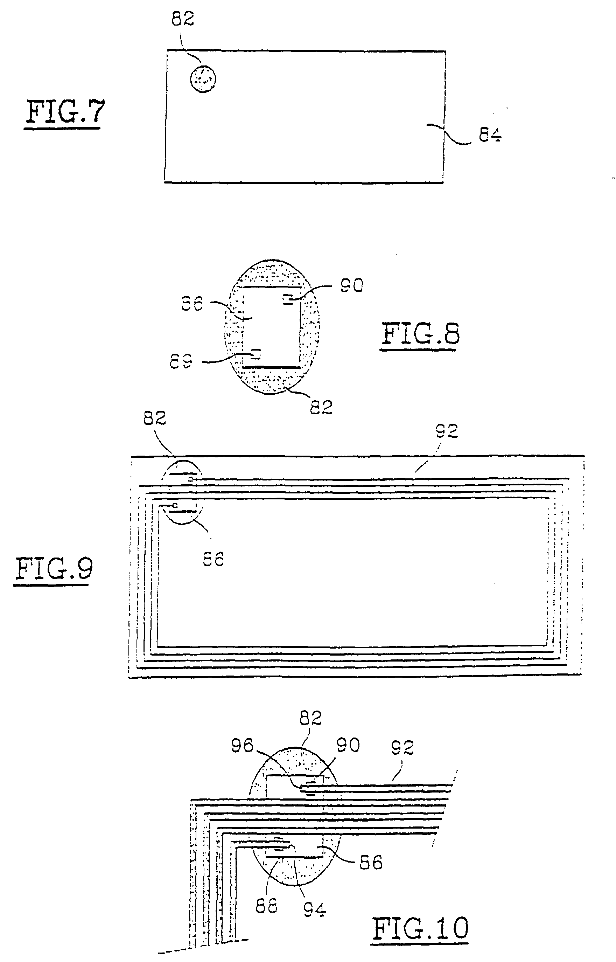

La figure 6 représente une carte à puce sans contact fabriquée conformément à un procédé selon l'invention. Elle comporte une antenne "à plat" constituée par une piste ayant, par exemple, la forme d'une spirale rectangulaire disposée à la périphérie de la carte comme représenté sur la figure 9.

Dans une première étape, on effectue un collage d'une puce 64 avec sa face active vers le haut à l'endroit choisi pour la connexion en utilisant un procédé et un équipement classique de "die attach" en utilisant une colle 66 permettant un collage sur un circuit imprimé ou un film. On choisit une colle compatible avec la température maximale d'utilisation du support de l'antenne, par exemple un adhésif réticulant sous l'effet d'une exposition à un rayonnement ultraviolet. La cadence de cette opération de collage peut être particulièrement élevée, par exemple cinq à six mille pièces à l'heure avec une seule tête. On s'attachera à obtenir un congé de colle parfaitement maîtrisé dans la zone du périmètre de la puce située en regard des plages de connexion 68 et 70 de l'antenne.

Dans une deuxième étape, on réalise des connexions électriques 72 et 74 en résine conductrice entre les plots de sortie 76 et 78 de la puce 80 et les plages de connexion 68 et 70 de l'antenne.

Cette deuxième étape peut aussi être réalisée avec la même cadence élevée de l'étape de collage de la puce. Ces deux étapes peuvent être réalisées sur un même équipement.

Selon une première variante, l'antenne à plat est réalisée par une technique de "dispense" et le collage de la puce est effectué par la technique de "flip chip" décrite ci-dessus.

Selon une autre variante illustrée sur les figures 7 à 10, on fixe d'abord la puce et on réalise l'antenne par une technique de "dispense" en passant sur la face active de la puce.

Dans une première étape (figure 7), on dépose par dispense un adhésif isolant 82, par exemple de type époxy, sur un support 84, par exemple en polychlorure de vinyle ou en polyéthylène, à l'endroit où on posera ensuite une puce munie de bosses de contact.

On pourrait ainsi utiliser des adhésifs destinés à la technique de "die attach" adaptés au support.

Dans une deuxième étape (figure 8), on place une puce 86 avec sa face active vers le haut sur l'adhésif 82 pour réaliser un collage de type "die attach". L'intérêt des bosses de contact est d'améliorer le contact électrique entre les plots de sortie 88 et 90 de la puce et l'antenne. On procédera éventuellement à une isolation des plots de sortie non fonctionnels en déposant un vernis diélectrique.

Dans une troisième étape (figure 9), on réalise l'antenne 92 par une technique de dispense d'une substance conductrice, par exemple une encre ou une colle, avec déplacement de la seringue en utilisant par exemple l'équipement CAM/ALOT cité ci-dessus.

On voit sur la figure 10 que les extrémités 94 et 96 de la spirale rectangulaire constituant l'antenne 92 recouvrent, respectivement, les plots de contacts 88 et 90 de la puce 86.

Dans une dernière et quatrième étape, on réalise une opération de colamination pour terminer la carte.

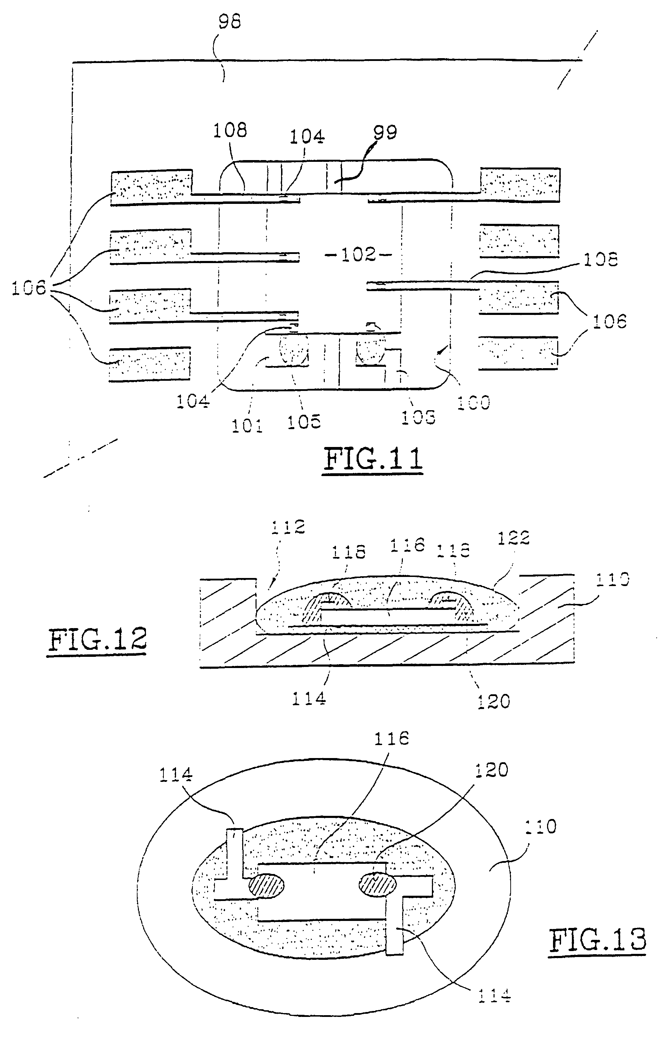

La figure 11 représente une carte à puce hybride fabriquée conformément à un procédé selon l'invention. Dans ce cas, on combine deux procédés précédemment décrits.

Dans une première étape, on réalise un corps de carte 98 comportant une antenne incorporée 99 comportant deux plots de contact 101 et 103. Dans une deuxième étape, on réalise une cavité 100 dans le corps de la carte. Dans une troisième étape, on fixe la puce 102 avec sa face active et ses plots de sortie 104, qui comportent de préférence une métallisation inoxydable, dans la cavité, par exemple par collage.

Dans une quatrième étape, on réalise le bornier de contacts 106 et ses connexions 108 avec les plots de sortie 104 de la puce et les connexions 105 des plots de contact 101 et 103 de l'antenne avec les plots de sortie 104 en déposant une résine conductrice 105 par une technique de dispense. Les plots 104 peuvent comporter des bosses de contact.

Les erreurs de positionnement angulaire de la puce 102 peuvent être corrigées comme décrit ci-dessus en utilisant un équipement de vision assistée par ordinateur.

Dans une cinquième et dernière étape, on réalise l'encapsulation de la puce.

L'invention s'applique à la fabrication de tous les dispositifs électroniques comprenant au moins un microcircuit qui est noyé dans une carte support et qui comporte des plots de sortie reliés à des éléments d'interface constitués par un bornier et/ou une antenne. En particulier, l'invention permet de fabriquer des étiquettes électroniques comme représenté sur les figures 12 et 13.

Un support 110 comporte une cavité 112 dans le fond de laquelle est réalisée une antenne 114. On y fixe ensuite un microcircuit 116 avec ses plots de sortie 118 vers le haut. On applique une résine conductrice 120 par une technique de dispense pour réaliser les connexions entre l'antenne 114 et les plots de sortie 118 de la puce. On réalise ensuite une encapsulation avec une résine isolante 122.

On voit que l'invention permet de supprimer la réalisation d'un micromodule et, en particulier l'opération de fraisage. Il en résulte de plus que le taux de rebuts de fabrication est très fortement réduit.

Par ailleurs le nombre des étapes est réduit, ce qui simplifie fortement la fabrication et entraîne une diminution importante prix de revient. Cet effet est encore accru par le fait que certaines opérations de collage de la puce et de réalisation des connexions peuvent être réalisées avec le même équipement.

L'invention n'utilise pas d'équipements coûteux, ce qui réduit les coûts de fabrication.

La réalisation de l'antenne par la technique de dispense permet d'obtenir une surface maximale et par suite, d'augmenter les performances de l'antenne par rapport aux antennes bobinées incorporées classiques.

L'invention permet de fabriquer, de manière simple et peu coûteuse des cartes complexes et de grandes dimensions.

La réalisation des connexions par la technique de "dispense" d'une substance qui reste souple après son activation permet de diminuer la rigidité et d'augmenter considérablement la résistance à la flexion-torsion des cartes à puce. Ainsi, les cartes à puce fabriqués conformément à l'invention ont une tenue aux contraintes qui est beaucoup plus élevée que celle imposée par les normes actuelles.

L'invention permet d'obtenir, avec un très faible taux de rebut comme on l'a indiqué plus haut, des cadences de fabrication élevées, par exemple de l'ordre de 4000 cartes à puce à l'heure.

## Revendications

1. Procédé de fabrication d'un dispositif électronique, tel qu'une carte à puce, comprenant au moins un microcircuit (44 ; 80 ; 86 ; 102) qui est noyé dans une carte support (40 ; 84 ; 98) et qui comporte des plots de sortie (46, 48 ; 76, 78 ; 88, 90 ; 104) reliés à des éléments d'interface constitués par un bornier (50, 52 ; 106) et/ou une antenne (70 ; 92 ; 99 ; 103) ; où l'on réalise les connexions (54, 56 ; 72, 74 ; 105 ; 108) entre les plots de sortie (46, 48 ; 76, 78 ; 88, 90 ; 104) et les éléments d'interface avec une substance conductrice ;
**caractérisé en ce que** la substance conductrice est déposée au moyen d'une seringue ou analogue, cette substance conductrice à faible viscosité restant souple après son application et sa polymérisation, et le dépôt étant réalisé avec un déplacement relatif du dispositif électronique et de la seringue.

2. Procédé selon la revendication 1, **caractérisé en ce que** le bornier (106) est aussi réalisé par dépôt de substance conductrice à faible viscosité.

3. Procédé selon la revendication 1, **caractérisé en ce qu'**une antenne (92) est aussi réalisée par dépôt de substance conductrice à faible viscosité.

4. Procédé selon l'une des revendications 1 à 3, **caractérisé en ce que** la substance est une résine polymère chargée de particules conductrices.

5. Procédé selon l'une des revendications 1 à 3, **caractérisé en ce que** la substance est une résine polymère chargée de particules intrinsèquement conductrices.

6. Procédé selon l'une des revendications 1 à 5, **caractérisé en ce que** le déplacement relatif du dispositif électronique et de la seringue est commandé par programme informatique.

7. Procédé selon la revendication 6, **caractérisé en ce que** l'on effectue une correction de position en réalisant une saisie d'image par un système de visualisation assistée par ordinateur.

8. Procédé selon la revendication 4, **caractérisé en ce que** la température d'activation de la substance est inférieure à la température de ramollissement de la matière thermoplastique constituant le corps de la carte.

9. Procédé selon l'une des revendications 1 à 8, **caractérisé en ce que** les plots de sortie comportent une métallisation inoxydable.

10. Procédé selon la revendication 2, **caractérisé en ce que** l'on réalise pour une carte à puce à contacts, un corps de carte (40) comportant une cavité (42), **en ce que** l'on fixe le microcircuit (44) avec sa face active vers le haut dans la cavité (42), **en ce que** l'on réalise le bornier (50, 52) et les connexions (54, 56) par dépôt de substance conductrice et **en ce que** l'on réalise une encapsulation du microcircuit (44).

11. Procédé selon la revendication 10, **caractérisé en ce que** le microcircuit (44) comporte des bosses de contact.

12. Procédé selon la revendication 10, **caractérisé en ce que** la cavité (58) présente un évidement (60) dans son fond (62) destiné à recevoir le microcircuit (44).

13. Procédé selon la revendication 1, **caractérisé en ce que** l'on réalise pour une carte à puce sans contact ou une étiquette électronique, une antenne à plat, **en ce que** l'on fixe le microcircuit (64) sur la carte avec sa face active vers le haut, et **en ce que** l'on réalise les connexions (72, 74) entre les plots de sortie (76, 78) du microcircuit et les plots (68, 70) de l'antenne par dépôt d'une substance conductrice à faible viscosité.

14. Procédé selon la revendication 1, **caractérisé en ce que** l'on réalise pour une carte à puce sans contact ou une étiquette électronique, une antenne à plat (92) par dépôt d'une substance conductrice à faible viscosité, **en ce que** l'on réalise des bosses de contact sur le microcircuit et **en ce que** l'on fixe le microcircuit avec sa face active vers le bas.

15. Procédé selon la revendication 1, **caractérisé en ce que** l'on dépose, au moyen d'une seringue ou analogue, un adhésif isolant (82) sur un support (84), **en ce que** l'on colle le microcircuit (86) avec sa face active vers le haut, **en ce que** l'on réalise une antenne à plat (92) directement sur le microcircuit (86) par dépôt d'une substance conductrice à faible viscosité, et **en ce que** l'on réalise une opération finale de colamination.

16. Procédé selon la revendication 2, **caractérisé en ce que** l'on réalise pour une carte à puce hybride, un corps de carte (98) comportant une antenne incorporée (99), **en ce que** l'on réalise une cavité (100) dans le corps de carte (98), **en ce que** l'on fixe le microcircuit (102) avec sa face active vers le haut dans la cavité, **en ce que** l'on réalise le bornier (106) et ses connexions (108) par dépôt d'une substance conductrice à faible viscosité et **en ce que** l'on réalise une encapsulation.

17. Procédé selon la revendication 16, **caractérisé en ce que** le microcircuit comporte des bosses de contact.

18. Procédé selon la revendication 16, **caractérisé en ce que** le dépôt d'une substance conductrice à faible viscosité est réalisé en corrigeant les erreurs de positionnement angulaire du microcircuit au moyen d'un système de vision assisté par ordinateur.

## Claims

1. A method for manufacturing an electronic device, such as a chip card, comprising at least one microcircuit (44; 80; 86; 102) which is embedded in a support card (40; 84; 98) and which has output pads (46, 48; 76, 78; 88, 90; 104) connected to interface elements consisting of a terminal block (50, 52; 106) and/or an antenna (70; 92; 99; 103); where the connections (54, 56; 72, 74; 105; 108) between the output pads (46, 48; 76, 78; 88, 90; 104 and the interface elements are produced with a conductive substance;
**characterised in that** the conductive substance is deposited by means of a syringe or the like, this low-viscosity conductive substance remaining flexible after its application and polymerisation, and the deposition being effected with a relative movement of the electronic device and the syringe.

2. A method according to Claim 1, **characterised in that** the terminal block (106) is also produced by the deposition of low-viscosity conductive substance.

3. A method according to Claim 1, **characterised in that** an antenna (92) is also produced by the deposition of a low-viscosity conductive substance.

4. A method according to one of Claims 1 to 3, **characterised in that** the substance is a polymer resin containing conductive particles.

5. A method according to one of Claims 1 to 3, **characterised in that** the substance is a polymer resin containing intrinsically conductive particles.

6. A method according to one of Claims 1 to 5, **characterised in that** the relative movement of the electronic device and syringe is controlled by computer program.

7. A method according to Claim 6, **characterised in that** a position correction is made by carrying out an image capture by means of a computer assisted display system.

8. A method according to Claim 4, **characterised in that** the temperature of activation of the substance is lower than the melting point of the thermoplastic material making up the card body.

9. A method according to one of Claims 1 to 8, **characterised in that** the output pads have a rust resistant metallisation.

10. A method according to Claim 2, **characterised in that** there is produced, for a chip card with contacts, a card body (40) having a cavity (42), **in that** the microcircuit (44) is fixed with its active face upwards in the cavity (42), **in that** the terminal block (50, 52) and the connections (54, 56) are produced by the deposition of conductive substance and **in that** an encapsulation of the microcircuit (44) is carried out.

11. A method according to Claim 10, **characterised in that** the microcircuit (44) has contact bumps.

12. A method according to Claim 10, **characterised in that** the cavity (58) has a recess (60) in its bottom (62) intended to receive the microcircuit (44).

13. A method according to Claim 1, **characterised in that** a flat antenna is produced for a contactless chip card or an electronic label, **in that** the microcircuit (64) is fixed to the card with its active face upwards, and **in that** the connections (72, 74) between the output pads (76, 78) of the microcircuit and the pads (68, 70) of the antenna are produced by the deposition of a low-viscosity conductive substance.

14. A method according to Claim 1, **characterised in that**, for a contactless smart card or an electronic label, a flat antenna (92) is produced by the deposition of a low-viscosity conductive substance, **in that** contact pads are produced on the microcircuit and **in that** the microcircuit is fixed with its active face downwards.

15. A method according to Claim 1, **characterised in that** an insulating adhesive (82) is deposited on a support (84) by means of a syringe or the like, **in that** the microcircuit (86) is glued with its active face upwards, **in that** a flat antenna (92) is produced directly on the microcircuit (86) by the deposition of a low-viscosity conductive substance, and **in that** a final co-lamination operation is performed.

16. A method according to Claim 2, **characterised in that**, for a hybrid card, a card body (98) having an incorporated antenna (99) is produced, **in that** a cavity (100) is produced in the card body (98), **in that** the microcircuit (102) is fixed with its active face upwards in the cavity, **in that** the terminal block (106) and its connections (108) are produced by the deposition of a low-viscosity conductive substance and **in that** an encapsulation is performed.

17. A method according to Claim 16, **characterised in that** the microcircuit has contact bumps.

18. A method according to Claim 16, **characterised in that** the deposition of a low-viscosity conductive substance is carried out by correcting the errors in angular positioning of the microcircuit by means of a computer assisted vision system.

## Patentansprüche

1. Herstellungsverfahren einer elektronischen Vorrichtung, z. B. einer Chipkarte mit mindestens einer Mikroschaltung (44; 80; 86; 102), die in ein Trägerelement (Karte) eingebettet (40, 84; 98) und mit Ausgangsbuchsen (46; 48; 76; 88; 90, 104) versehen ist, welche an Schnittstellenelemente, bestehend aus einem Anschlussblock (50; 52; 106) und/oder einer Antenne (70; 92; 99; 103) angeschlossen werden, an denen die Anschlüsse (54; 56; 72; 74; 105; 108) zwischen den Ausgangsbuchsen (46; 48; 76; 78; 88; 90; 104) und den Schnittstellenelementen mit einer leitfähigen Substanz hergestellt werden,
die **dadurch gekennzeichnet ist, dass** sie mit Hilfe einer Nadel oder einem ähnlichen Gerät deponiert wird; diese leitfähige, nicht allzu zähflüssige Substanz bleibt sowohl nach der Applikation als auch nach der Aushärtung biegsam und erfolgt in einer Relativbewegung der elektronischen Vorrichtung und der Nadel.

2. Verfahren nach Patentanspruch 1, das **dadurch gekennzeichnet ist, dass** auch der Anschlussblock (106) durch das Deponieren einer leitfähigen, nicht allzu zähflüssigen Substanz hergestellt wird.

3. Verfahren nach Patentanspruch 1, das **dadurch gekennzeichnet ist, dass** auch eine Antenne (92) durch das Deponieren einer leitfähigen, nicht allzu zähflüssigen Substanz hergestellt wird.

4. Verfahren nach einem der Patentansprüche 1 bis 3, das **dadurch gekennzeichnet ist, dass** die Grundlage der Substanz ein Harzpolymer mit leitfähigen Partikeln ist.

5. Verfahren nach einem der Patentansprüche 1 bis 3, das **dadurch gekennzeichnet ist, dass** die Grundlage der Substanz ein Harzpolymer mit eigenleitfähigen Partikeln ist.

6. Verfahren nach einem der Patentansprüche 1 bis 5, das **dadurch gekennzeichnet ist, dass** die Relativbewegung der elektronischen Vorrichtung und der Nadel durch ein EDV-Programm gesteuert wird.

7. Verfahren nach Patentanspruch 6, das **dadurch gekennzeichnet ist, dass** eine mögliche Korrekur der Position mit Hilfe eines über ein computergestütztes Anzeigesystem erfassten Bildes erfolgt.

8. Verfahren nach Patentanspruch 4, das **dadurch gekennzeichnet ist, dass** die Aktivierungstemperatur der Substanz unter der Erweichungstemperatur des thermoplastischen Materials des Karten-Hauptteils liegt.

9. Verfahren nach einem der Patentansprüche 1 bis 8, das **dadurch gekennzeichnet ist, dass** die Ausgangsbuchsen mit einem Metallbelag versehen sind.

10. Verfahren nach Patentanspruch 2, das **dadurch gekennzeichnet ist, dass** für die Herstellung einer Chipkarte mit Kontakt ein Karten-Hauptteil (40) mit einer Austiefung (42), in welcher (42) die Mikroschaltung (44) mit ihrer aktiven Seite nach oben fixiert wird, dass der Anschlussblock (50, 52) und die Anschlüsse (54, 56) durch das Deponieren einer leitfähigen Substanz gefertigt werden und dann die Einkapselung der Mikroschaltung (44) erfolgt.

11. Verfahren nach Patentanspruch 10, das **dadurch gekennzeichnet ist, dass** die Mikroschaltung (44) mit Kontaktbuckeln versehen ist.

12. Verfahren nach Patentanspruch 10, das **dadurch gekennzeichnet ist, dass** die Austiefung (58) auf ihrem Boden (62) über eine weitere Vertiefung (Tasche) (60) verfügt, die für die Aufnahme der Mikroschaltung bestimmt ist (44).

13. Verfahren nach Patentanspruch 1, dass **dadurch gekennzeichnet ist, dass** für die Herstellung einer kontaktlosen Chipkarte oder eines elektronischen Etiketts folgende Arbeitsschritte durchgeführt werden: Herstellen einer Flachantenne, Fixieren der Mikroschaltung (64) auf dem Chip, wobei ihre aktive Seite nach oben zeigt, Herstellen der Anschlüsse (72, 74) zwischen den Ausgangsbuchsen (76, 78,) der Mikroschaltung und den Buchsen (68, 70) der Antennen durch das Deponieren einer leitfähigen, nicht allzu zähflüssigen Substanz.

14. Verfahren nach Patentanspruch 1, das **dadurch gekennzeichnet ist, dass** für die Herstellung einer kontaktlosen Chipkarte oder eines elektronischen Etiketts, eine Flachantenne (92) durch das Deponieren einer leitfähigen, nicht allzu zähflüssigen Substanz gefertigt wird, dass Kontaktbuckel auf einer Mikroschaltung hergestellt werden und dass die Mikroschaltung mit ihrer aktiven Seite nach unten zeigend fixiert wird.

15. Verfahren nach Patentanspruch 1, dass **dadurch gekennzeichnet ist, dass** ein isolierender Klebstoff (82) mit Hilfe einer Nadel oder einem ähnlichen Gerät auf einer Unterlage (84) deponiert wird, dass die Mikroschaltung (86) mit der aktiven Seite nach oben fixiert wird, dass direkt auf der Mikroschaltung (86) eine Flach-Antenne (92) durch das Deponieren einer leitfähigen, nicht allzu zähen Substanz hergestellt wird und dass am Ende eine Überwalzung erfolgt.

16. Verfahren nach Patentanspruch 2, dass **dadurch gekennzeichnet ist, dass** für die Herstellung einer Hybridkarte ein Karten-Hauptteil (98) mit integrierter Antenne (99) gefertigt, ferner eine eine Austiefung (100) in das Karten-Hauptteil (98) gearbeitet, die Mikroschaltung (102) in die Austiefung geklebt wird (aktive Seite zeigt nach oben), der Anschlussblock (106) und seine Anschlüsse (108) durch das Deponieren einer leitfähigen, nicht allzu zähen Substanz hergestellt werden und eine Einkapselung erfolgt.

17. Verfahren nach Patentanspruch 16, das **dadurch gekennzeichnet ist, dass** die Mikroschaltung mit Kontaktbuckeln versehen ist.

18. Verfahren nach Patentanspruch 16, das **dadurch gekennzeichnet ist, dass** das Deponieren einer leitfähigen nicht allzu zähen Substanz erfolgt, wobei Fehler bei der Winkelpositionierung der Mikroschaltung mit Hilfe eines computergestützten Anzeigesystems korrigiert werden.
